# EUROPEAN PATENT SPECIFICATION

(11) **EP 3 099 141 B1**
(45) Date of publication and mention of the grant of the patent: **18.12.2019**
(21) Application number: 16170736.9
(22) Date of filing: 20.05.2016
(51) Int. Cl.: H05B 33/08, F21K 99/00, H05K 1/18, F21S 4/28

(54) **A LIGHTING DEVICE AND CORRESPONDING METHOD**
BELEUCHTUNGSVORRICHTUNG UND ZUGEHÖRIGES VERFAHREN
DISPOSITIF D'ÉCLAIRAGE ET PROCÉDÉ CORRESPONDANT

(30) Priority: 26.05.2015 IT UB20151245
(43) Date of publication of application: 30.11.2016
(73) Proprietor: OSRAM GmbH, 80807 München (DE); OSRAM S.P.A. - SOCIETA' RIUNITE OSRAM EDISON CLERICI, 20126 Milano (IT)
(72) Inventor: MUNARIN, Marco, I-31038 Paese (Treviso) (IT); GRIFFONI, Alessio, I-30030 Fossò (Venezia) (IT); DIDONE, Roberto, I-36027 Rosà (Vicenza) (IT)
(74) Representative: Bosotti, Luciano

(56) References cited:
- WO-A1-2009/146257
- WO-A2-2006/129291
- WO-A2-2014/013400
- DE-A1- 19 950 388
- DE-U1-202004 011 869
- DE-U1-202004 011 869
- US-A- 5 463 280
- US-A1- 2008 191 632

## Description

### Technical Field

The present description relates to lighting devices.

One or more embodiments may refer to lighting devices employing solid-state light radiation sources, such as LED sources.

### Technological Background

The introduction and the increasingly widespread use of solid-state light radiation sources, such as LED sources, has opened new possibilities of implementation of lighting devices.

This is true e.g. for the retrofitting replacement of existing traditional light radiation sources, such as filament lamps, thereby offering improved mechanical, electrical, thermal and optical performances.

In such a context, the device is expected to satisfy the following requirements:
- an (almost) omnidirectional radiation pattern;
- a wide range of Correlated Colour Temperatures (CCTs), e.g. from 2700°K to 6500 °K,
- the possibility of plugging the light engine into the housing without having to consider the electrical supply polarity, with the consequent possibility of activating the lighting device regardless of the polarity (e.g. with the possibility of operating either with a positive feed voltage V_{DD} or with a negative feed voltage V_{SS}, e.g. in the automotive sector),
- compact size.

The fulfilment of all these requirements may constitute a challenge.

In order to activate a light radiation source regardless of the feed voltage polarity, a rectifier circuit may be used. This solution, however, is not always practicable, e.g. when the size of the light source is supposed to be small and compact.

In order to achieve an (almost) omnidirectional radiation pattern, in the use of conventional LED sources (with a lambertian or narrower radiation pattern) secondary optics may be resorted to. They may be lenses, reflectors, polymeric materials with scattering features (e.g. comprising Al₂O₃) or light guides. These solutions may require a remarkable design effort and may lead to a reduced optical efficiency.

Another solution for achieving the same goals may involve the use of LED filaments. These may however equally require rectifier circuits, in order to be activated regardless of the electrical polarity. Moreover, as regards CCT features, the available range of LED filaments is narrow.

Document DE 20 2004 011 869 U1 discloses a device comprising two diodes which are connected in antiparallel with a pulse-width modulator supplying current to the light-emitting diodes in alternating directions. The diodes are preferably mounted in the same housing, and/or emit light of different wavelengths, e.g. red and blue.

Document WO 2006/129291 A2 discloses a light emitting diode (LED) assembly and module including a substrate having opposing first and second sides; a capacitor having first and second electrically-conductive plates respectively disposed proximate the first and second sides of the substrate; and an anti-parallel LED structure electrically connected to the first electrically-conductive plate and thermally coupled to the substrate.

Also WO 2014/013400 A2, WO 2009/146257 A1 and DE 199 50 388 A1 are of interest for the invention.

### Object and Summary

One or more embodiments aim at overcoming the previously outlined drawbacks.

According to one or more embodiments, said object is achieved thanks to a lighting device having the features specifically set forth in claim 1 that follows.

One or more embodiments may also concern a corresponding method as per claim 7.

The claims are an integral part of the technical teaching provided herein with reference to the embodiments.

One or more embodiments may lead to the implementation of a LED lighting source activatable regardless of the supply polarity.

One or more embodiments may employ Chip Scale Package (CSP) light emitting diodes (LEDs), adapted to exhibit a 150° or larger radiation pattern and being available in a wide range of CCTs and colours.

In one or more embodiments, such radiation sources may be mounted on both sides of a planar support, such as a Printed Circuit Board (PCB), and may be connected, e.g. through electrically conductive lines such as vias extending through said support, thus enabling the reversal of current flow direction due to the reversal of feed voltage polarity.

One or more embodiments may offer one or more of the following advantages:
- an almost omnidirectional radiation pattern,
- the possibility of plugging in the lighting device without considering the electrical polarity, such possibility being achieved without resorting to additional rectifier circuitry,
- a compact size, e.g. due to the possible use of CSP LEDs, having a smaller footprint than other LEDs.

### Brief Description of the Figures

One or more embodiments will now be described, by way of non-limiting example only, with reference to the annexed Figures, wherein:
- Figure 1 is a schematic view of a lighting device according to one or more embodiments,
- Figures 2 and 3 symbolically show the operation of one or more embodiments,
- Figure 4 is a block diagram of one or more embodiments,
- Figures 5 and 6 are plan views of a light radiation emitting portion in one or more embodiments with the features of the invention as claimed shown in Figure 6,
- Figures 7 and 8 exemplify, in a block diagram and in a possible plan view of a light radiation emitting portion, possible modifications according to one or more embodiments.

It will be appreciated that, for ease of understanding, the views in the various Figures may not be drawn to the same scale.

### Detailed Description

In the following description, numerous specific details are given to provide a thorough understanding of exemplary embodiments. One or more embodiments may be practiced without one or several specific details, or with other methods, components, materials, etc. In other instances, well-known structures, materials, or operations are not shown or described in detail to avoid obscuring various aspects of the embodiments.

Reference throughout this specification to "one embodiment" or "an embodiment" means that a particular feature, structure, or characteristic described in connection with the embodiment is included in at least one embodiment. Thus, the possible appearances of the phrases "in one embodiment" or "in an embodiment" in various places throughout this specification are not necessarily all referring to the same embodiment. Furthermore, particular features, structures, or characteristics may be combined in any suitable manner in one or more embodiments.

The headings provided herein are for convenience only, and therefore do not interpret the extent of protection or the scope of the embodiments.

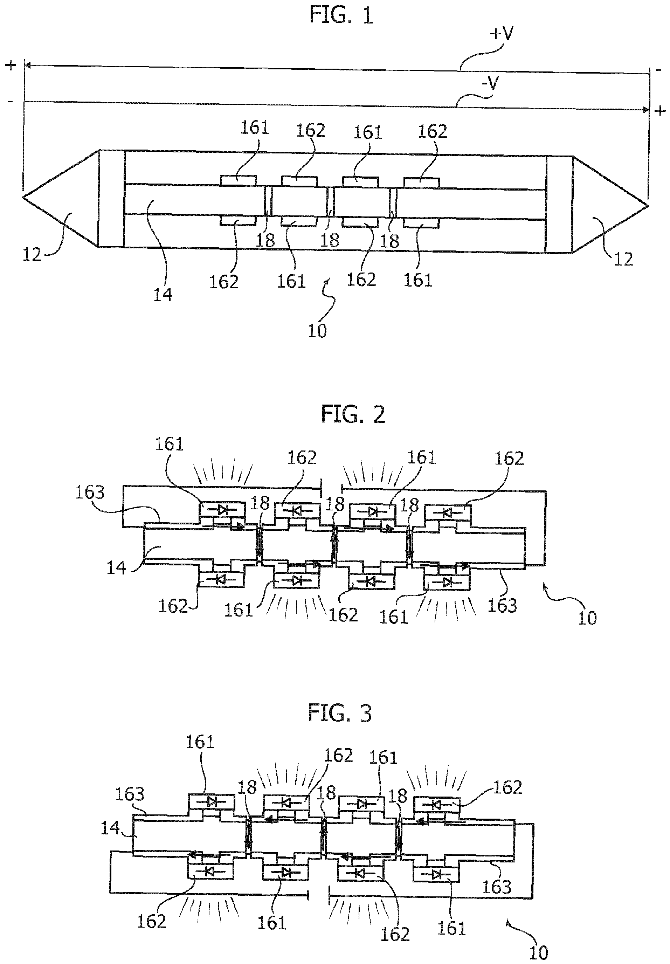

In Figure 1, reference 10 denotes on the whole a lighting device.

In one or more embodiments, the lighting device may be adapted to be used as a "retrofit" device, in order to replace a filament lamp. Possible applications concern e.g. the automotive sector or indoor lighting.

Of course, the references to the possible use as a retrofit device and to the possible application fields are purely exemplary and do not limit the embodiments.

In one or more embodiments, device 10 may be comprised (again by way of non-limiting example) of an elongated bar, optionally mounted in a transparent, or in any case light-permeable, tubular case.

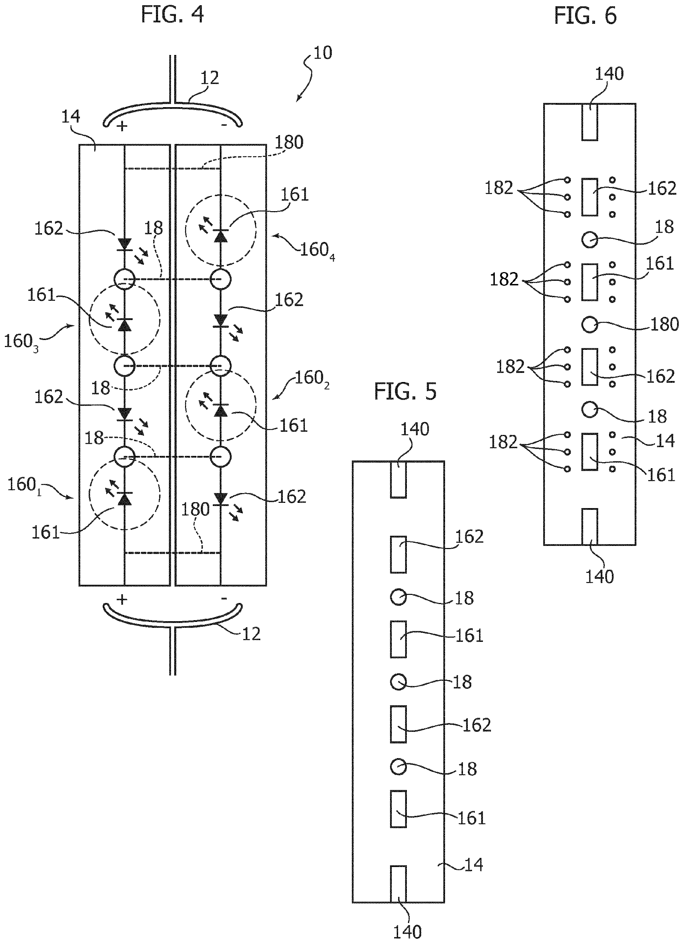

In one or more embodiments, device 10 may have two end electrical contacts (rheophores) 12, a support structure 14 extending therebetween and consisting, in one or more embodiments, of a (small) board or Printed Circuit Board (PCB), e.g. a FR-4 board, which may contain end pads 140 (see e.g. Figures 5, 6 and 8) in order to achieve electrical contact with rheophores 12.

In one or more embodiments device 10 may comprise, as light radiation sources, electrically-powered solid-state light radiation sources, such as sources comprising Light Emitting Diodes (LEDs).

In one or more embodiments, such LEDs may comprise "first" LEDs 161 and "second" LEDs 162 mounted on support 14 (according to criteria better detailed in the following), in such a way as to take into account (e.g. considering the possible applications outlined in the introductory section of the present specification) the fact that the polarity of feed voltage V applied across contacts or rheophores 12 may have opposed polarities, and therefore may be a "positive" voltage +V (or V_{DD}) or a "negative" voltage -V (V_{SS}).

The problem of the polarity or direction of the feed voltage is not present in traditional filament lamps, the behaviour whereof varies according to the polarity. The issue of the polarity of feed voltage, on the contrary, is critical in the case of LED sources, which exhibit a diode-like behaviour, being adapted to emit light when the feed voltage has a definite polarity (positive anode with respect to the cathode).

One or more embodiments may base their operation on the criterion schematically shown in Figures 2 and 3:
- when the feed voltage of device 10 has a first polarity (Figure 2), "first" LEDs 161 are activated, and
- when the feed voltage has a reversed polarity (Figure 3), "second" LEDs 162 are activated.

In one or more embodiments, such operation may involve the presence of electrically conductive, e.g. copper, lines 18 (e.g. so-called "vias" extending through support 14).

As exemplified by the arrows in Figures 2 and 3, conductive lines 18 are adapted to implement a current flow path which:
- in the operating conditions exemplified in Figure 2 (first polarity of feed voltage) goes through a series of "first" LEDs 161, i.e. from a LED 161 (above left in Figure 2) located on the upper side or face of support 14 to a LED 161 located on the opposed, i.e. lower, side of support 14, and then goes back to a further LED 161 on the upper side of the support and ends at a further LED 161 on the lower side of support 14, and
- in the operating conditions exemplified in Figure 3 (the polarity of feed voltage being opposed to the former) goes through a series of "second" LEDs 161, i.e. from a LED 162 (below right in Figure 3) located on the lower side or face of support 14 to a LED 162 located on the opposed, i.e. upper, side of support 14, and then goes back to a further LED 162 on the lower side of the support and ends at a further LED 162 on the upper side of support 14.

In one or more embodiments, the LEDs (either the "first" LEDs 161 or the "second" LEDs 162) may be mounted on the opposed sides or faces of support 14 via known techniques, e.g. with a solder paste.

For example, in one or more embodiments, on one side of the support a solder paste may be used having a higher melting point than the solder paste employed on the second side. In this way, the mounting of LEDs (first LEDs 161 or second LEDs 162) on the second side does not affect the mounting conditions of the LEDs already provided on the other side.

In one or more embodiments, for the mounting of LEDs 161, 162 on the opposed sides of support 14 it is possible to resort to electrically conductive adhesives, e.g. conductive glues.

The number of LEDs mounted on support 14 may be chosen at will, and may be varied e.g. on the basis of the desired luminous flux, the path of electrically conductive lines 163 connecting LEDs 161, 162 on both sides of support 14 being adapted correspondingly.

As may be appreciated in Figures 2 and 3, in one or more embodiments LEDs having the same polarity (i.e. LEDs 161 on one hand and LEDs 162 on the other hand) are arranged alternatively on both sides of support 14. As exemplified by the electrical symbol of the diode which they exhibit in Figures 2 and 3, in one or more embodiments LEDs 161 and 162 form, on each side of support 14, a string of LEDs in "anti-series", i.e. each LED of one kind (161 resp. 162) being flanked by at least one LED of the other kind (162 resp. 161).

In this way, in one or more embodiments on each side of support 14 two LED "strings" may be obtained which comprise the same number of LEDs so that, in accordance with the polarity of the feed voltage V applied across rheophores 12, there may be alternatively obtained, as exemplified in Figures 2 and 3:
- either the activation of LEDs 161,
- or the activation of LEDs 162.

In this way the possibility is given of achieving the activation of device 10 irrespective of the polarity (+V or -V) of feed voltage V, and therefore of obtaining a behaviour of device 10 which is not affected by the polarity of feed voltage V.

In one or more embodiments, LEDs 161 and 162 may be Chip Scale Package (CSP) LEDs. In this way, thanks to a radiation pattern (150° or higher) which is wider than the lambertian patterns of conventional LEDs, and optionally thanks to the LED distribution on both sides of support 14, the purpose may be achieved of obtaining an (almost) omnidirectional light radiation pattern of device 10.

Figure 4 shows, in a block diagram, possible connections among LEDs 161 and 162, also as regards possible embodiments other than exemplified herein.

With reference to a device 10 as shown in Figures 1 to 3 (i.e. a device comprising four first LEDs 161 and four second LEDs 162), the diagram in Figure 4 exemplifies that, as observed among contacts 12, the electrical connection among such LEDs may be considered ad a series connection of a plurality of LED cells (160₁, 160₂, 160₃, 160₄) activatable by a feed voltage applied across said series connection.

In one or more embodiments, cells 160₁, 160₂, 160₃, 160₄ may be present in a number other than four, which is merely exemplary.

According to the commonly accepted definition, by "series-connected cells" we mean cells that are connected along a single current path, so that the same current flows through all series-connected cells.

In the presently exemplified embodiments, the series connection comprises a plurality of cells 160₁, 160₂, 160₃, 160₄, each cell comprising in turn a first LED 161 and a second LED 162 arranged in an "anti-parallel" connection, i.e. a parallel connection with reversed polarities.

In this case as well, according to the commonly accepted definition, by "parallel-connected components" (in this case LED diodes) we mean components to which the same voltage is applied.

As may be seen in the block diagram of Figure 4, due to the "anti-parallel" arrangement, i.e. a parallel arrangement with reversed polarities, in each cell 160₁, 160₂, 160₃, 160₄:
- where the anode of first diode 161 is present, there is provided the cathode of second diode 162, and
- where the cathode of first diode 161 is present, there is provided the anode of second diode 162.

The reference to diodes 161, 162 "arranged" in parallel in the various cells 160ᵢ (which are series-connected to one another) takes into account that, in one or more embodiments, the actual cross-connection of anode-cathode and cathode-anode between both diodes 161, 162 may be provided (e.g. by means of conductive lines or vias 18) in "internal" cells such as cells 160₂ and 160₃, which are located at an intermediate position in the series connection. For cells 160₁, 160₄, which on the contrary are located "externally", i.e. at an end position of the series connection, the connections between anode and cathode of both LEDs 161, 162 located externally in the series connection - i.e. the connections denoted with 180 in Figure 4 - may be unnecessary on support 14. Such connections may be implemented, for example, by contacts or rheophores 12 or, optionally, even by the contacts of the lighting device (headlight, luminaire, etc.) wherein device 10 is mounted.

While keeping the possibility for first and second LEDs 161 and 162 to be activatable alternatively (Figure 2 or Figure 3) as a function of the polarity of the feed voltage V applied to the series connection of cells 160₁, ......, 160₄, in one or more embodiments the arrangement on opposed sides of a planar support may not be mandatory.

For example, in one or more embodiments, both arrays or strings of LEDs 161, 162, which in Figures 2 and 3 are shown on opposed sides of support 14, may be arranged side by side.

The activatability of the first LEDs 161 when voltage V has a first polarity (+V or V_{DD}) and the activatability of the second LEDs 162 when voltage V has a second polarity (-V, V_{SS}), opposed to the first, is independent from the possibility of arranging first LEDs 161 and second LEDs 162 on opposed sides of support 14.

Therefore, the solution exemplified in the Figures, with first LEDs 161 arranged on both sides of support 14 and second LEDs 162 equally arranged on both sides of support 14, optionally with each first LED 161 flanked by at least one second LED 161 or vice versa, as in the examples shown in Figures 2 and 3, is by no means mandatory.

In one or more embodiments LEDs 161, 162 may be chosen as to be equal to each other, so that device 10 emits light radiation in approximately identical conditions irrespective of the polarity of feed voltage V.

In one or more embodiments, on the contrary, the first LEDs 161 and the second LEDs 162 may be mutually different, e.g. as regards one or more of the following features:
- the different colour temperature of the radiation emitted by LEDs 161 as compared to LEDs 162,
- the different colour of the radiation emitted by LEDs 161 as compared to LEDs 162,
- the different luminous flux intensity emitted by LEDs 161 as compared to LEDs 162.

In this way, in one or more embodiments, although keeping activatability irrespective of the polarity of feed voltage 10, device 10 may have different emission features (e.g. a different colour temperature, a different emission colour or a different emission intensity) on the basis of the polarity or direction of the feed voltage.

In this way, in one or more embodiments, a lighting device 10 may be obtained which exhibits different emission features, e.g. on the basis of the mounting position thereof.

For the same reason, in one or more embodiments, the various cells 160₁, ......, 160₄ may have, instead of a symmetric structure (one first diode 161 and one second diode 162 arranged in parallel with reversed polarities), an asymmetric structure (e.g. with two LEDs connected in parallel having a first polarity and another LED arranged in parallel with the first ones, but with an opposite polarity), while keeping the provision, in each cell 160₁, ......, 160₄, of a first LED 161 and of a second LED 162 with reversed polarities.

Figures 5 and 6, wherein the parts or the elements which have already been described referring to other Figures are denoted by the same reference numbers or symbols, may be considered as plan views of one of the sides of support 14 (e.g. the face above in Figures 2 and 3).

Such Figures exemplify that, in one or more exemplified embodiments, each first LED 161 may be flanked by one or two second diodes 162, with connections or vias 18 extending between mutually contiguous diodes 161 and 162 (it should be recalled once again that similar end connections, denoted with 180 in Figure 4, may be unnecessary in one or more embodiments).

Figure 6 highlights the possibility of providing, according to the invention as claimed, in addition to electrical vias or lines 18, further thermally conductive lines or vias, denoted as 182 and arranged e.g. on opposed sides of each LED 161, 162, in order to enhance the dissipation of the heat produced by LEDs 161 or 162 in operation.

As in the case of lines or vias 18, these vias may be obtained by filling holes provided in support 14 with an electrically conductive material, e.g. copper (filled and capped vias).

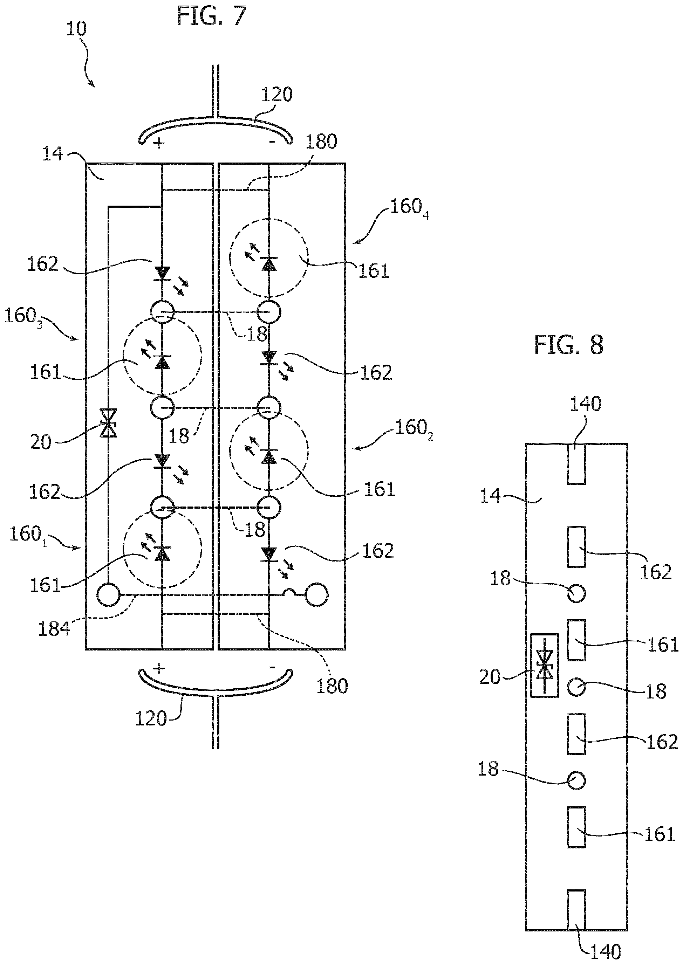

Figures 7 and 8, wherein the parts or elements that have previously been described referring to the other Figures are denoted with the same reference numbers or symbols, show the possibility of providing a protective element against Electrostatic Discharge (ESD) or Electrical Over Stress (EOS), arranged across the series connection of the various cells 160₁, ......, 160₄.

In one or more embodiments the element may comprise e.g. a so-called Transient Voltage Suppression (TVS) diode 20.

In one or more embodiments, a single protection diode 20 may be used which acts across the series connection of cells 160₁, ......, 160₄, by providing a further conductive line 184 (Figure 7) connecting both LED strings arranged on both sides of support 14.

One or more embodiments as exemplified herein may be used e.g. in the automotive sector, in order to implement lighting devices 10 adapted to be supplied with a 12V (negative or positive) voltage.

One or more embodiments may envisage feed voltages having a different value, optionally employing a number of cells 160₁, 160₂, 160₃, 160₄ of LEDs 161, 162 which may be either higher or lower than the number (four) of cells shown herein by way of example only.

Of course, without prejudice to the basic principles, the implementation details and the embodiments may vary, even appreciably, with respect to what has been described herein by way of non-limiting example only, without departing from the extent of protection.

The extent of protection is defined by the annexed claims.

## Claims

1. A lighting device (10) including a series connection of a plurality of cells (160₁, ..., 160₄) of light emitting diodes activatable by a feed voltage (+V, -V) applied across said series connection, wherein said cells (160₁, ..., 160₄) of light emitting diodes include a first diode (161) and a second diode (162) arranged in parallel with opposed polarities, wherein said first diodes (161) and said second diodes (162) are alternatively activatable as a function of the polarity of the voltage (+V, -V) applied across the series connection of said cells (160₁, ..., 160₄) of light emitting diodes, the lighting device, including:
- a support member (14) having first and second sides, and
- said first (161) and second (162) diodes arranged on both said first and said second side of the support member (14)
wherein:
- said support member (14) is a laminar support member with opposed first and second planar sides,
- the lighting device includes thermally conductive vias (182) extending through said laminar support member (14), and
- at both said first and said second side of the support member (14) each said first diode (161) is flanked by at least one said second diode (162), with diodes having the same polarity (161, resp. 162) arranged alternatively on both sides of the support member (14).

2. The lighting device of claim 1, wherein said first diodes (161) and said second diodes (162) are in equal number at both said first and second sides of the support member (14).

3. The lighting device of claim 1 or claim 2, wherein said support member (14) is a printed circuit board.

4. The lighting device of any of the previous claims, wherein said series connection of a plurality of cells (160₁, ..., 160₄) of light emitting diodes includes two end cells (160₁, 160₄) for applying said feed voltage (+V, -V) and at least one intermediate cell (160₂, 160₃) therebetween, the device including electrically conductive lines (18) connecting, in said at least one intermediate cell (160₂, 160₃):
- the cathode of the first diode (161) to the anode of the second diode (162), and
- the anode of the first diode (161) to the cathode of the second diode (162).

5. The lighting device of any of the previous claims, wherein said light emitting diodes (161, 162) include Chip Scale Package light emitting diodes.

6. The lighting device of any of the previous claims, including a bidirectional protection element, preferably a transient voltage suppression diode (20), across said series connection of cells (160₁, ..., 160₄) of light emitting diodes.

7. A method of producing a lighting device (10), including:
- connecting in series a plurality of cells (160₁, ..., 160₄) of light emitting diodes to produce a series connection of said plurality of cells (160₁, ..., 160₄) activatable by a feed voltage (+V, -V) applied across said series connection, and
- including in said cells (160₁, ..., 160₄) a first diode (161) and a second diode (162) arranged in parallel with opposed polarities, wherein said first diodes (161) and said second diodes (162) are alternatively activatable as a function of the polarity of the voltage (+V, -V) applied across the series connection of said cells (160₁, ..., 160₄) of light emitting diodes,
the method including:
- providing a support member (14) having first and second sides, and
- arranging said first (161) and second (162) diodes on both said first and said second side of the support member (14)
wherein:
- said support member (14) is a laminar support member with opposed first and second planar sides,
- the lighting device includes thermally conductive vias (182) extending through said laminar support member (14), and
- at both said first and said second side of the support member (14) each said first diode (161) is flanked by at least one said second diode (162), with diodes having the same polarity (161, resp. 162) arranged alternatively on both sides of the support member (14).

## Patentansprüche

1. Beleuchtungsvorrichtung (10), die eine Reihenschaltung einer Vielzahl von Zellen (160₁..., 160₄) von lichtabstrahlenden Dioden beinhaltet, die durch eine Zuführspannung (+V, -V) aktivierbar ist, die über die Serienschaltung angelegt wird, wobei die Zellen (160₁..., 160₄) der lichtabstrahlenden Dioden eine erste Diode (161) und eine zweite Diode (162) beinhalten, die parallel mit entgegengesetzten Polaritäten angeordnet sind, wobei die ersten Dioden (161) und die zweiten Dioden (162) alternierend als eine Funktion der Polarität der Spannung (+V, -V) aktivierbar sind, die über der Serienschaltung der Zellen (160₁..., 160₄) der lichtabstrahlenden Dioden angelegt wird, die Beleuchtungsvorrichtung beinhaltend:
- ein Trägerelement (14) aufweisend erste und zweite Seiten, und
- die ersten (161) und zweiten (162) Dioden, die auf der ersten und der zweiten Seite des Trägerelements (14) angeordnet sind, wobei:
- das Trägerelement (14) ein laminares Trägerelement mit gegenüberliegenden ersten und zweiten planar Seiten ist,
- die Beleuchtungsvorrichtung thermisch leitfähige Durchführungen (182) beinhaltet, die sich durch das laminare Trägerelement (14) erstrecken, und
- an sowohl der ersten Seite als auch der zweiten Seite des Trägerelements (14) jede erste Diode (161) von mindestens einer der zweiten Diode (162) flankiert wird, wobei Dioden mit derselben Polarität (161, bzw. 162) alternierend an beiden Seiten des Trägerelements (14) angeordnet sind.

2. Beleuchtungsvorrichtung nach Anspruch 1, wobei die ersten Dioden (161) und die zweiten Dioden (162) sich in gleicher Anzahl auf der ersten als auch der zweiten Seite des Trägerelements (14) befinden.

3. Beleuchtungsvorrichtung nach Anspruch 1 oder Anspruch 2, wobei das Trägerelement (14) eine Leiterplatte ist.

4. Beleuchtungsvorrichtung nach einem der vorhergehenden Ansprüche, wobei die Serienschaltung einer Vielzahl von Zellen (160₁..., 160₄) von lichtabstrahlenden Dioden zwei Endzellen (160₁ 160₄) zum Anlegen der Zuführspannung (+V, -V) und mindestens eine Zwischenzelle (160₂, 160₃) dazwischen beinhaltet, wobei die Vorrichtung elektrisch leitfähige Leitungen (18) beinhaltet, die in der mindestens einen Zwischenzelle (160₂, 160₃) Folgendes verbinden:
- die Kathode der ersten Diode (161) mit der Anode der zweiten Diode (162), und
- die Anode der ersten Diode (161) mit der Kathode der zweiten Diode (162).

5. Beleuchtungsvorrichtung nach einem der vorhergehenden Ansprüche, wobei die lichtabstrahlenden Dioden (161, 162) Chip Scale Package lichtabstrahlende Dioden beinhalten.

6. Beleuchtungsvorrichtung nach einem der vorhergehenden Ansprüche, beinhaltend ein bidirektionales Schutzelement, bevorzugt eine Suppressordiode (20) über der Serienschaltung von Zellen (160₁..., 160₄) von lichtabstrahlenden Dioden.

7. Verfahren zum Herstellen einer Beleuchtungsvorrichtung (10), beinhaltend:
- Serienschalten einer Vielzahl von Zellen (160₁,..., 160₄) von lichtabstrahlenden Dioden zum Herstellen einer Serienschaltung der Vielzahl von Zellen (160₁,..., 160₄), die durch eine Zuführspannung (+V, -V) aktivierbar sind, die über die Serienschaltung angelegt wird, und
- Beinhalten, in den Zellen (160₁..., 160₄), einer ersten Diode (161) und einer zweiten Diode (162), die parallel mit entgegengesetzten Polaritäten angeordnet sind, wobei die ersten Dioden (161) und die zweiten Dioden (162) als eine Funktion der Polarität der Spannung (+V, -V) alternierend aktivierbar sind, wobei die Spannung über die Serienschaltung der Zellen (160₁..., 160₄) von lichtabstrahlenden Dioden angelegt ist,
das Verfahren beinhaltend:
- Bereitstellen eines Trägerelements (14) aufweisend erste und zweite Seiten, und
- Anordnen der ersten (161) und zweiten (162) Dioden an der ersten als auch der zweiten Seite des Trägerelements (14),
wobei:
- das Trägerelement (14) ein laminares Trägerelement mit gegenüberliegenden ersten und zweiten planaren Seiten ist,
- die Beleuchtungsvorrichtung thermisch leitfähige Durchführungen (182) beinhaltet, die sich durch das laminare Trägerelement (14) erstrecken, und
- an der ersten als auch der zweiten Seiten des Trägerelement (14) jede erste Diode (161) von mindestens einer der zweiten Diode (162) flankiert wird, wobei Dioden aufweisend dieselbe Polarität (161, bzw. 162) alternierend an beiden Seiten des Trägerelements (14) angeordnet werden.

## Revendications

1. Un dispositif d'éclairage (10) comprenant un montage en série d'une pluralité de cellules (160₁, ..., 160₄) de diodes électroluminescentes activables par une tension d'alimentation (+V, -V) appliquée aux bornes dudit montage en série, lesdites cellules (160₁, ..., 160₄) de diodes électroluminescentes comprenant une première diode (161) et une seconde diode (162) agencées en parallèle avec des polarités opposées, lesdites premières diodes (161) et lesdites secondes diodes (162) étant activables en alternance en fonction de la polarité de la tension (+V, -V) appliquée aux bornes du montage en série desdites cellules (160₁, ..., 160₄) de diodes électroluminescentes, le dispositif d'éclairage comprenant :
- un organe support (14) ayant un premier et un second côté, et
- lesdites premières (161) et secondes (162) diodes agencées sur l'un et l'autre dudit premier et dudit second côtés de l'organe support (14),
dans lequel :
- ledit organe support (14) est un organe support laminaire avec des premier et second côtés plans opposés,
- le dispositif d'éclairage comprend des vias thermiquement conducteurs (182) s'étendant au travers dudit organe support laminaire (14), et
- au niveau à la fois dudit premier et dudit second côté de l'organe support (14) chacune desdites premières diodes (161) est flanquée par au moins l'une desdites secondes diodes (162), les diodes ayant la même polarité (161, resp. 162) étant agencées en alternance sur l'un et l'autre côté de l'organe support (14).

2. Le dispositif d'éclairage de la revendication 1, dans lequel lesdites premières diodes (161) et lesdites secondes diodes (162) sont en nombre égal sur l'un et l'autre desdits premier et second côté de l'organe support (14).

3. Le dispositif d'éclairage de la revendication 1 ou de la revendication 2, dans lequel ledit organe support (14) est une carte de circuit imprimé.

4. Le dispositif d'éclairage de l'une des revendications précédentes, dans lequel ledit montage en série d'une pluralité de cellules (160₁, ..., 160₄) de diodes électroluminescentes comprend deux cellules d'extrémité (160₁, 160₄) pour l'application de ladite tension d'alimentation (+V, -V) et au moins une cellule intermédiaire (160₂, 160₃) situées entre elles, le dispositif comprenant des lignes électriquement conductrices (18) reliant, dans ladite au moins une cellule intermédiaire (160₂, 160₃) :
- la cathode de la première diode (161) à l'anode de la seconde diode (162), et
- l'anode de la première diode (161) à la cathode de la seconde diode (162).

5. Le dispositif d'éclairage de l'une des revendications précédentes, dans lequel lesdites diodes électroluminescentes (161, 162) comprennent des diodes électroluminescentes en Chip Scale Package.

6. Le dispositif d'éclairage de l'une des revendications précédentes, comprenant un élément de protection bidirectionnelle, de préférence une diode de suppression de tension transitoire (20), aux bornes dudit montage en série de cellules (160₁, ..., 160₄) de diodes électroluminescentes.

7. Un procédé de production d'un dispositif d'éclairage (10), comprenant :
- la liaison en série d'une pluralité de cellules (160₁, ..., 160₄) de diodes électroluminescentes pour produire un montage en série de ladite pluralité de cellules (160₁, ..., 160₄) pouvant être activées par une tension d'alimentation (+V, -V) appliquée aux bornes dudit montage en série, et
- l'inclusion dans lesdites cellules (160₁, ..., 160₄) d'une première diode (161) et d'une seconde diode (162) agencées en parallèle avec des polarités opposées, lesdites premières diodes (161) et lesdites secondes diodes (162) étant activables en alternance en fonction de la pluralité de la tension (+V, -V) appliquée aux bornes du montage en série desdites cellules (160₁, ..., 160₄) de diodes électroluminescentes,
le procédé comprenant :
- l'obtention d'un organe support (14) ayant un premier et un second côté, et
- l'agencement desdites premières (161) et secondes (162) diodes sur l'un et l'autre dudit premier et second côté de l'organe support (14),
dans lequel :
- ledit organe support (14) est un organe support laminaire avec des premier et second côtés plans opposés,
- le dispositif d'éclairage comprend des vias thermiquement conducteurs (182) s'étendant au travers dudit organe support laminaire (14), et
- au niveau à la fois dudit premier et dudit second côté de l'organe support (14) chacune desdites premières diodes (161) est flanquée par au moins l'une desdites secondes diodes (162), les diodes ayant la même polarité (161, resp. 162) étant agencées en alternance sur l'un et l'autre côté de l'organe support (14).
